# Europäisches Patentamt
## European Patent Office
## Office européen des brevets

(19)

(11) Veröffentlichungsnummer: **0 349 556 B1**

(12) **EUROPÄISCHE PATENTSCHRIFT**

(45) Veröffentlichungstag der Patentschrift: **18.11.93**

(51) Int. Cl.5: **H01J 37/32**, H05H 1/46

(21) Anmeldenummer: **88902396.6**

(22) Anmeldetag: **16.03.88**

(86) Internationale Anmeldenummer:
**PCT/DE88/00157**

(87) Internationale Veröffentlichungsnummer:
**WO 88/07262 (22.09.88 88/21)**

(54) **VERFAHREN UND VORRICHTUNG ZUR BEARBEITUNG VON FESTKÖRPEROBERFLÄCHEN DURCH TEILCHENBESCHUSS.**

(30) Priorität: **18.03.87 DE 3708717**

(43) Veröffentlichungstag der Anmeldung:
**10.01.90 Patentblatt 90/02**

(45) Bekanntmachung des Hinweises auf die Patenterteilung:
**18.11.93 Patentblatt 93/46**

(84) Benannte Vertragsstaaten:
**AT BE CH DE FR GB IT LI LU NL SE**

(56) Entgegenhaltungen:
**EP-A- 0 106 497**
**DE-A- 2 933 850**
**US-A- 4 401 054**

**Patent Abstracts of Japan, Band 6, Nr. 111 (E-114)(989), 22. Juni 1982, & JP-A-5740932**

**Patent Abstracts of Japan, Band 8, Nr. 246 (C-251)(1683), 10. November 1984, & JP-A-59126778**

(73) Patentinhaber: **Oechsner, Hans, Professor Dr. rer nat.**
**Vogelweher Strasse 76**
**D-67661 Kaiserslautern(DE)**

(72) Erfinder: **Oechsner, Hans, Professor Dr. rer nat.**
**Vogelweher Strasse 76**
**D-67661 Kaiserslautern(DE)**

(74) Vertreter: **Liesegang, Roland, Dr.-Ing. et al**
**FORRESTER & BOEHMERT**
**Franz-Joseph-Strasse 38**
**D-80801 München (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3.10/3.6/3.3.1)

**Beschreibung**

Die Erfindung betrifft ein Verfahren zur Abtragung und Strukturierung von Festkörperoberflächen, zur Herstellung von Oberflächendotierungen durch Teilchenbeschuß und zum Erzeugen von Oberflächenschichten.

Der möglichst großflächige Beschuß von Festkörper-Oberflächen mit Atom- oder Molekülstrahlen ist ein wichtiger Prozeß für die moderne Oberflächen- und Dünnschicht-Technologie. Dabei ist der Bereich von Teilchenenergien zwischen einigen 10 Elektronenvolt bis zu einigen Kilo-Elektronenvolt von besonderer Bedeutung, da in diesem Fall die ablaufenden Wechselwirkungsprozesse auf einige wenige bis wenige 10 Atomlagen an der Oberfläche begrenzt bleiben.

Die Anwendungen solcher Teilchenstrahlquellen lassen sich generell in zwei Gruppen unterteilen:

1. Durch den Teilchenbeschuß werden aus der Oberfläche des beschossenen Festkörpers Atome und Moleküle des jeweiligen Materials ausgelöst.(Festkörper-Zerstäubung durch Ionenbeschuß oder "Sputtering"). Die herausgeschlagenen Oberflächenteilchen fliegen durch das in der entsprechenden Beschußapparatur erzeugte Vakuum und können auf entsprechenden Trägern (Substraten) aufgefangen werden, wo sie dünne Schichten oder Dünnschichtssysteme aus dem Material des zerstäubten Festkörpers aufbauen. In entsprechenden Anordnungen können gleichzeitig mehrere Festkörper-Targets durch den Beschuß mit Atomen oder Molekülen zerstaubt werden. Weiter kann dieser Prozeß unter Anwesenheit bestimmter Gase oder Gasgemische in der entsprechenden Vakuumkammer erfolgen. Damit lassen sich in sehr flexibler Weise Schichten oder Schichtsysteme von nahezu beliebiger chemischer Zusammensetzung erzeugen.

Der durch den Teilchenbeschuß hervorgerufene Abtrag der beschossenen Oberfläche selbst ist ebenfalls von großer technologischer Bedeutung. Auf diese Weise lassen sich beispielsweise Oberflächenkontaminations-Schichten oder Oberflächenverunreinigungen entfernen, d.h. Substrate für den nachfolgenden Beschichtungsprozeß atomar reinigen. Besonders wichtig für die moderne Mikroelektronik, aber auch für andere Gebiete wie z.B. die integrierte Optik, ist die gezielte Strukturierung von Oberflächen durch großflächigen Teilchenbeschuß. Dazu werden durch einen fotografischen Prozeß oder mit anderen Mitteln auf eine Festkörper-Oberfläche Strukturen aus einem Material aufgebracht, das gegenüber dem Teilchenbeschuß erhöhte Resistenz aufweist. Unter Teilchenbeschuß werden dann die nicht abgedeckten Bereiche der jeweiligen Oberfläche atomar abgetragen und damit die Oberfläche in die Tiefe strukturiert. Die charakteristischen Abmessungen solcher Strukturen können in der Breite bis herab in den Submikrometer-Bereich variiert werden, die Tiefe je nach Beschußdauer vom Nanometer- bis in den Mikrometer-Bereich. Dieser als Sputterätzen oder Ionenstrahlätzen (Ion Beam Etching, IBE) bezeichnete Prozeß zeichnet sich dadurch aus, daß er ohne chemisch aggressive Flüssigkeiten, d.h. sehr umweltfreundlich arbeitet und wegen der Anisotropie des benutzten Abtragungs-Prozesses sehr steile Flanken der erzeugten Strukturen liefert. Benutzt man für den Beschuß chemisch reaktive Teilchen oder führt den Beschuß unter Anwesenheit reaktiver Gase durch, so kann die Oberflächenstrukturierung durch beschußinduzierte chemische Reaktionen zusätzlich verstärkt werden (reaktives Sputterätzen oder Reactive Ion Beam Etching, RIBE).

2. Der zweite Anwendungsbereich des großflächigen Teilchenbeschusses von Oberflächen beruht darauf, daß Strahlteilchen in die Oberfläche eingebaut werden und dort häufig eine chemische Reaktion verursachen, wobei einmal die Tiefe der Reaktionszone durch die Eindringtiefe der energiereichen Teilchen gegeben ist und die Reaktionsgeschwindigkeit durch die von den Teilchen mitgebrachte Energie in vorteilhafter Weise erhöht wird. Benutzt man beispielsweise Teilchenstrahlen aus Kohlenstoffatomen oder Kohlenwasserstoffmolekülen, so lassen sich an metallischen Oberflächen dünne Karbidschichten bilden. Analog entstehen bei der Verwendung von Teilchenstrahlen aus Sauerstoff- oder Stickstoffteilchen dünne "intrinsische", d.h. fest mit dem Material verwachsene Oberflächenschichten aus Oxiden oder Nitriden des jeweils beschossenen Materials. Solche Oberflächenschichten weisen häufig sehr günstige mechanische Eigenschaften auf und wirken daher beispielsweise stark verschleißmindernd gegenüber Reibung oder erhöhen die Standzeit von spanabhebenden Bearbeitungswerkzeugen. Weiterhin können solche Schichten durch die erfolgte Absättigung freier chemischer Oberflächenvalenzen passivierend gegenüber dem Angriff korrosiver Gase oder Flüssigkeiten wirken. Benutzt man großflächige Strahlen aus Metallatomen oder Metallmolekülen, so läßt sich durch den Einbau der Strahlteilchen an ursprünglich elektrisch isolierenden Oberflächen eine dünne leitfähige Oberflächenschicht beispielsweise an Keramikbauteilen erzeugen. Ein wichtiges Beispiel für den Einsatz von großflächigen Strahlen aus Metallatomen oder -molekülen in der Dünnschichttechnik ist die Oberflächenmetallisierung isolierender oder halbleitender Substrate. Dies stellt einen wichtigen Prozeßschritt bei der Erzeugung integrierter mikroelektronischer Schaltungen und Bauteile dar.

Für diese beispielhaft genannten Anwendungen werden bekanntermaßen vorwiegend Ionenstrahlen geeigneter Konfiguration eingesetzt, da sich elektrisch geladene Teilchen durch elektrische Felder auf einfache Weise beschleunigen lassen. Von erheblichem Nachteil hierbei ist, daß die von den Ionen mitgebrachte elektrische Ladung über den jeweils beschossenen Festkörper abgeführt werden muß. Dies ist nur bei Metallen oder entsprechend gut leitenden Halbleitermaterialien gewährleistet. Bei schlecht leitenden Materialien oder bei Isolatoren kommt es sehr rasch zu einer Aufladung der beschossenen Oberfläche. Durch das dann entstehende elektrische Gegenfeld werden die Beschußionen abgebremst und der erwünschte Oberflächenbeschuß kommt zum Erliegen. Weist die Oberfläche infolge aufgebrachter Masken nichtleitende Bereiche auf, so kommt es durch die dort entstehenden Aufladungen zu elektrischen Störfeldern, die den erwähnten Strukturierungsvorgang erheblich beeinträchtigen können. Zur Umgehung dieser sehr störenden Effekte muß man durch geeignet angeordnete Elektronenquellen dem beschossenen Werkstück zusätzlich Elektronen anbieten. Dies bedeutet eine mitunter erhebliche technische Komplikation, die sich insbesondere bei großflächigem Ionenbeschuß nicht in befriedigender Weise beheben läßt.

Großflächige Ionenstrahlquellen lassen sich bisher im übrigen nur in Form eines Bündels aus zahlreichen Einzelstrahlen realisieren. Damit ergeben sich lateral nicht gleichmäßige Stromdichteverteilungen über den gesamten Bündelbereich, was die Einsatzmöglichkeiten von solchen großflächigen Ionenstrahlquellen ebenfalls erheblich begrenzt. Zur Erzielung einer ausreichenden Homogenität des Ionenabtrags ist es häufig erforderlich, das beschossene Werkstück in technisch komplizierter Weise quer zur Richtung des Beschußstrahlbündels periodisch zu bewegen.

Aus DE-A- 2 933 850 ist eine Plasma-Ätzvorrichtung bekannt, bei der in einer Hochfrequenz-Plasmadiode die eine der beiden hochfrequenzführenden Elektroden als Sieb ausgebildet ist, durch dessen Maschen ein Teil des Plasmas hindurchdringt. Mit dieser Vorrichtung ist es nicht möglich, ein Werkstück gezielt mit einem Plasmastrahl zu beschießen.

In US-A- 4 401 054 wird eine Mikrowellenentladung und Elektronen-Zyclotron-Resonanz aufrechterhalten und daraus das Plasma mit Hilfe von Beschleunigungseffekten in einem divergenten magnetischen Gleichfeld auf ein Werkstück bzw. Substrat geführt. Der Plasmastrahl ist dabei grundsätzlich divergent und damit lateral inhomogen, demnach für viele Zwecke nicht anwendbar.

Der Erfindung liegt die Aufgabe zugrunde, ein Verfahren zur Abtragung und Strukturierung von Festkörperoberflächen, zur Herstellung von Oberflächendotierungen und zum Erzeugen von Oberflächen-Schichten durch Teilchenbeschuß aus einem Plasma zu schaffen, mit dem die aufgezeigten Nachteile vermieden werden.

Diese Aufgabe wird erfindungsgemäß durch Anspruch 1 gelöst.

Eine erfindungsgemäße Vorrichtung zum Durchführen des angegebenen Verfahrens kann dadurch verwirklicht werden, daß ein Plasmagefäß mit zwei großflächigen Elektroden vorgesehen ist, die über ein Anpassungsnetzwerk mit einem Hochfrequenzgenerator verbunden sind und daß die Flächen der Elektroden so gewählt sind, daß nahezu die gesamte Hochfrequenzspannung an einer als feines Gitter ausgebildeten Extraktionselektrode, deren Öffnungen kleiner sind als die Dicke der Raumladungsschicht zwischen dieser Extraktionselektrode und dem Plasma, abfällt.

Nach einer weiteren Ausbildung der Erfindung ist vorgesehen, daß die weitere Elektrode topfförmig ausgebildet ist und in das Innere des Plasmagefäßes ragend angeordnet ist.

Eine andere Ausbildung der Erfindung besteht darin, daß die weitere Elektrode topfförmig ausgebildet und auf das Plasmagefäß aufgesetzt ist.

Eine besondere Ausbildung der Erfindung ist darin zu sehen, daß die weitere Ekektrode das Plasmagefäß außen umfassend angeordnet ist.

Im Rahmen der Erfindung liegt es auch, wenn die als feines Gitter ausgebildete Extraktionselektrode auf einer selbsttätig wirkenden Nachspann-Vorrichtung befestigt ist.

Erfindungsgemäß kann vorgesehen sein, daß die Stege der als feines Gitter ausgebildeten Extraktionselektrode in Isolator-Material eingebettet sind.

Die mit der Erfindung erzielten Vorteile bestehen insbesondere darin, daß bei Verwendung eines Plasmastrahls die eingangs geschilderten Nachteile nicht zu verzeichnen sind. Dieser Plasmastrahl besteht zum einen aus der zum Teilchenbeschuß benötigten positiven Ionenkomponente, führt jedoch in gleicher Zahl bzw. Dichte Elektronen mit sich. Ein solcher Plasmastrahl ist daher als Ganzes gesehen elektrisch neutral. Beim Beschuß schlecht leitender oder elektrisch isolierender Oberflächen kommt es daher zu keiner den Arbeitsvorgang störenden elektrischen Aufladung. Auch Leitfähigkeitsänderungen während der Beschußzeit, die etwa durch den Aufbau elektrisch isolierender Oberflächen auf einem ursprünglich elektrisch leitenden Werkstück verursacht werden, stören die Oberflächenbehandlung mit einem solchen Plasmastrahl nicht. Ebenso wirkt es nicht störend, wenn bestimmte Oberflächenbereiche etwa durch das Aufbringen isolierender Masken zur Oberflächenstrukturierung durch Teilchenbeschuß elektrisch nicht leitend sind, d.h. die elektrische Leitfähigkeit an der zu behandelnden Oberfläche örtlich wechselt. Aufgrund der "Quasi-Neutralität" des aus positiven Ionen und negativen Elektronen bestehenden Plasmastrahls sind zusätzliche Elektronenquellen oder andere Maßnahmen wie im Falle der Verwendung von reinen Ionenstrahlen nicht mehr erforderlich.

Ein erfindungsgemäß erzeugter Plasmastrahl weist gegenüber den bereits erwähnten großflächigen Ionenstrahl-Bündelquellen einen weiteren entscheidenden Vorteil auf: Aufgrund der speziellen Erzeugungsart ist die Stromdichteverteilung in einem solchen Plasmastrahl quer zur Strahlrichtung völlig homogen und weist keinerlei Modulationsstruktur auf. Dies ermöglicht einen völlig homogenen großflächigen Abtrag von Werkstoffoberflächen oder eine Oberflächenstrukturierung unter an allen Orten des beschossenen Bereiches stets identischen Bedingungen.

Anhand der Zeichnungen, die auch Ausführungsbeispiele für Vorrichtungen zum Durchführen des Verfahrens enthalten, wird die Erfindung näher erläutert.

Es zeigen
Fig. 1
eine Darstellung zur Erläuterung des Arbeitsprinzips der Plasmastrahlquelle,
Fig. 2
schematisch den Aufbau der Strahlquelle,
Fig. 3, Fig. 4 und Fig. 5
verschiedene Ausführungen für die Elektroden,
Fig. 6
schematisch eine Anordnung zum Beschuß von Werkstücken,
Fig. 7, Fig 8 und Fig. 9
denkbare Ausführungen für die Extraktionselektrode,
Fig. 10
eine Nachspannvorrichtung für die Extraktionselektrode und
Fig. 11
eine besondere Ausführung für die Extraktionselektrode, ausschnittweise, in vergrößertem Maßstab.

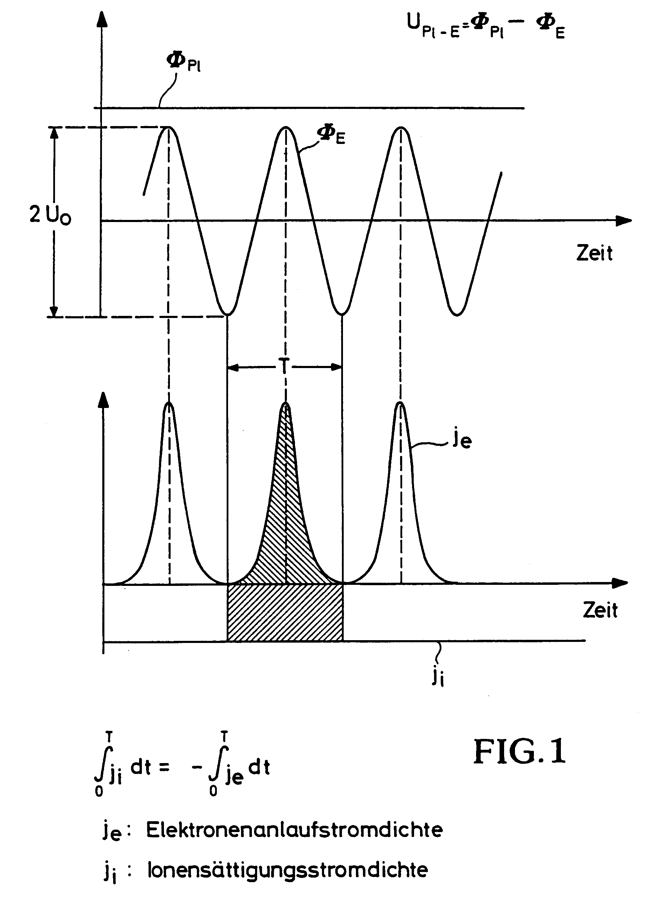

Zur Erzeugung des Plasmastrahls wird ein physikalischer Effekt benutzt, der auftritt, wenn eine Hochfrequenz führende Elektrode in Kontakt mit einem irgendwie erzeugten Niederdruck-Plasma gebracht wird. Betrachtet man den zeitlichen Verlauf (Fig. 1) der auf eine solche Elektrode aus dem Plasma fließenden Ströme aus elektrisch geladenen Teilchen, so können während einer Periode der Hochfrequenzspannung zwischen dem Plasma und dieser Elektrode positive Plasmaionen auf diese Elektrode fließen, solange sie negativ gegen das Plasma ist. Andererseits fließen Plasmaelektronen auf diese Elektrode, sofern sie auf positivem elektrischen Potential gegenüber dem Plasma ist. Darüber hinaus erreichen Plasmaelektronen aufgrund ihrer mit einer kinetischen Energie verknüpften relativ hohen Temperatur die Elektrode auch dann, wenn sie nicht zu stark negativ gegen das Plasma ist; es fließt dann ein Elektronenanlaufstrom.

Wäre nun eine solche hochfrequenzführende Elektrode jeweils während einer halben Hochfrequenzperiode positiv oder negativ gegenüber dem Plasma, so würden pro Periodendauer aufgrund ihrer höheren Beweglichkeit und Geschwindigkeit ungleich mehr Plasmaelektronen auf die Elektrode fließen als umgekehrt positive Plasmaionen. Dies ist jedoch aufgrund der Quasi-Neutralitätsbedingung für ein elektrisches Gasentladungsplasma nicht möglich, die besagt, daß in einem Plasma pro Volumeneinheit stets gleich viele positive und negative Ladungen Vorhanden sein müssen. Diese Bedingung ist im allgemeinen durch den Plasma-Erzeugungsprozeß selbst vorgegeben. Generell gilt jedoch, daß es zum Aufbau einer elektrischen Raumladung kommen würde, wenn der Verlust einer bestimmten Ladungsträger-Komponente überwiegen würde. Das Vorseichen der sich aufbauenden Raumladung wäre dem der das Plasma verlassenden Ladungsträger-Komponente entgegengesetzt und würde so den Abfluß dieser Komponente verhindern.

Als Folge dieses Selbststeuerungsverhaltens legt sich ein elektrisches Gasentladungsplasma gegen eine hochfrequenzführende Elektrode von selbst auf ein ausreichend hohes positives Potential. Durch diesen "selfbiasing"-Effekt wird bewirkt, daß während der ganzen Periodendauer der Hochfrequenzspannung Ionen auf die Elektrode fließen können und daß nur während eines kurzen Zeitintervalls innerhalb einer Hochfrequenz-Periode ein entsprechender Elektronenpuls auf die Elektrode fließt, nämlich dann, wenn innerhalb einer Hochfrequenz-Periode Plasma und Elektrode sich potentialmäßig kurzzeitig nähern. Auf diese Weise wird erreicht, daß sich während einer Hochfrequenz-Periode die Zahl der das Plasma verlassenden positiven Ionen und Elektronen genau kompensiert, d.h. es fließt auf eine solche hochfrequenzführende Elektrode kein Gleichstrom, sondern lediglich ein elektrischer Verschiebungsstrom.

Die hier skizzierten Verhältnisse sind in Fig. 1 dargestellt. Daraus wird ersichtlich, daß sich zur Aufrechterhaltung der Quasi-Neutralität des Plasmas zwischen dem Plasma und der hochfrequenzführenden Elektrode eine Gleichspannung $U_{PI-E}$ einstellt, die in guter Näherung der Amplitude der Hochfrequenz-Spannung entspricht. $U_{PI-E}$ ist in der Regel um eine Teilspannung der Größenordnung $kT_e/e_0$ (k Boltzmann-Konstante, $T_e$ Elektronentemperatur, $e_0$ Elementarladung) größer als die Hochfrequenz-Amplitude $U_0$, da die Elektronen aufgrund ihrer relativ hohen Eigenenergie gegen eine zusätzliche kleine Bremsspannung der Größenordnung $kT_e/e_0$ anlaufen können.

Mit dem beschriebenen Verhalten ist das Prinzip der Plasmastrahlquelle beschrieben. Die hochfrequenzführende Elektrode wird als geeignet konfiguriertes Drahtnetz oder in Form parallel verlaufender Drähte ausgeführt und durch eine geeignete hochfrequenztechnische Anordnung wird dafür gesorgt, daß sich zwischen einem Niederdruck-Plasma und dieser "Extraktionselektrode" unter Ausnutzung des beschriebenen Effektes eine ionenbeschleunigende Potentialdifferenz ausbildet, die aus der Überlagerung einer Hochfrequenz-Spannung geeigneter Frequenz f und Amplitude $U_0$ sowie der sich ausbildenden Gleichspannung der Höhe $U_0 + kT_e/e_0$ besteht.

Zwischen dem Plasma und der Extraktionselektrode bildet sich dann die aus der physikalischen Fachliteratur bekannte Schottky-Langmuische Raumladungsschicht aus, deren Dicke d der Beziehung

$$d = (4\epsilon_0/9j_i)^{1/2} (2e_0/M_i)^{1/4} U^{3/4} \qquad (1)$$

genügt. Dabei bedeutet im vorliegenden Fall

$j_i$      die extrahierte Ionenstromdichte
$U$      den elektrischen Spannungsabfall in der Raumladungsschicht
$\epsilon_0$      die Dielektrizitätskonstante des Vakuums
$M_i$      die Masse der extrahierten Ionen.

Während einer Hochfrequenz-Periode variiert die Spannung U um den Wert der "selfbiasing"-Spannung $U_0 + kT_e / e_0$ nach oben und um den Betrag $U_0$ der Hochfrequenz-Amplitude nach unten.

Positive Plasmaionen werden vom Plasmapotential aus durch den Potentialabfall in der Raumladungsschicht vor der Extraktionselektrode auf diese zu beschleunigt und verlassen dann durch diese hindurch den Plasmaraum in Richtung auf die zu beschießende Festkörper-Oberfläche. Da, wie bereits beschrieben, dem über die ganze Periodendauer hinweg fließenden Ionenstrom pro Hochfrequenz-Periode jeweils ein Elektronenpuls so überlagert wird, daß der aus dem Plasma fließende Gesamtstrom unter Berücksichtigung der Ladungsvorzeichen der bei den Teilchenarten gerade null wird, entsteht auf diese Weise ein Plasmastrahl.

Wählt man die Frequenz f der benutzten Hochfrequenz-Spannung so hoch, daß die Ionen auf ihrem Weg durch die Raumladungsschicht, deren Dicke d ebenfalls mit der Frequenz f oszilliert, hinreichend viele Hochfrequenz-Perioden erleben, so läßt sich durch eine einfache Rechnung zeigen, daß die Ionenenergie im extrahierten Plasmastrahl in guter Näherung durch das sich einstellende "selfbiasing"-Potential bestimmt wird. Die kinetische Energie der Ionenkomponente im Plasmastrahl ist daher in guter Näherung bis auf Abweichungen in der Größenordnung $kT_e$ durch die Amplitude der zwischen Extraktionselektrode und Plasma abfallenden Hochfrequenz-Spannung gegeben. Bei einfach positiv geladenen Ionen beträgt demnach die kinetische Ionenenergie $E_i \cong e_0 \, U_0$.

Das Gasentladungsplasma, aus dem der Plasmastrahl auf die beschriebene Weise extrahiert wird, kann auf beliebige Art erzeugt werden. Besonders naheliegend ist es, das Plasma mittels Hochfrequenz-Energie zu erzeugen, d.h. den für die Plasmastrahl-Extraktion erforderlichen Hochfrequenzgenerator gleichzeitig zur Plasmaanregung zu benutzen.

Für Plasmastrahlquellen, bei denen die Extraktion eines Plasmastrahls nach dem hier beschriebenen Prinzip erfolgt, ist die Verwendung einer kapazitiven Anordnung zur Plasmaerzeugung besonders vorteilhaft. Eine entsprechende Anordnung wird für die hier beschriebene Plasmastrahlquelle benutzt.

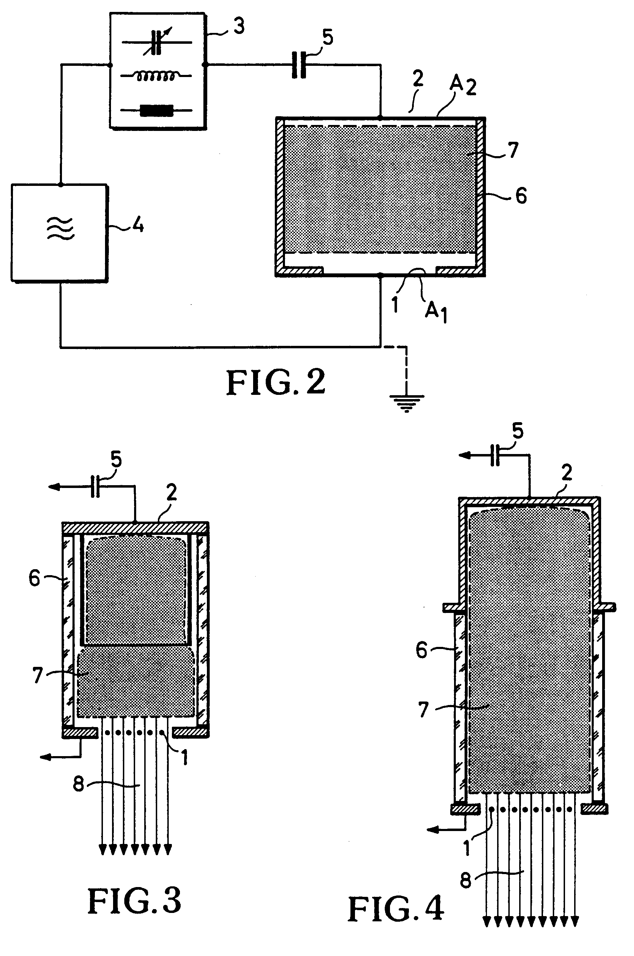

Der prinzipielle Aufbau der Plasmastrahlquelle ist in Fig. 2 dargestellt. Zwischen zwei Elektroden 1, 2 mit den Flächen $A_1$ und $A_2$ wird ein elektrisches Hochfrequenzfeld erzeugt, mit dessen Hilfe ein Gas, das sich in einem Plasmagefäß 6 unter vermindertem Druck zwischen den beiden Elektroden befindet, teilweise ionisiert wird. Dazu wird über ein geeignetes Anpassungsnetzwerk 3 aus Induktivitäten, Kapazitäten und gegebenenfalls Ohmschen Widerständen eine Hochfrequenz-Spannungsquelle 4 in Form eines Hochfrequenz-Generators an die beiden Elektroden 1, 2 angeschlossen. Die beiden Elektroden 1, 2 dieser kapazitiven Anordnung stellen im obigen Sinne hochfrequenzführende Elektroden gegen das erzeugte Niederdruckplasma 7 dar. Da, wie oben beschrieben, auf solchen Elektroden nur ein Verschiebungsstrom fließt, ist es unerheblich, ob die beiden metallischen Elektroden 1, 2 in unmittelbarem Kontakt mit dem Plasma stehen oder etwa über eine isolierende Gefäßwand, durch die der Verschiebungsstrom hindurch fließt, vom Inneren des Plasmaraumes getrennt sind. Weiter können geeignete Kapazitäten 5 in den Hochfrequenzkreis geschaltet werden.

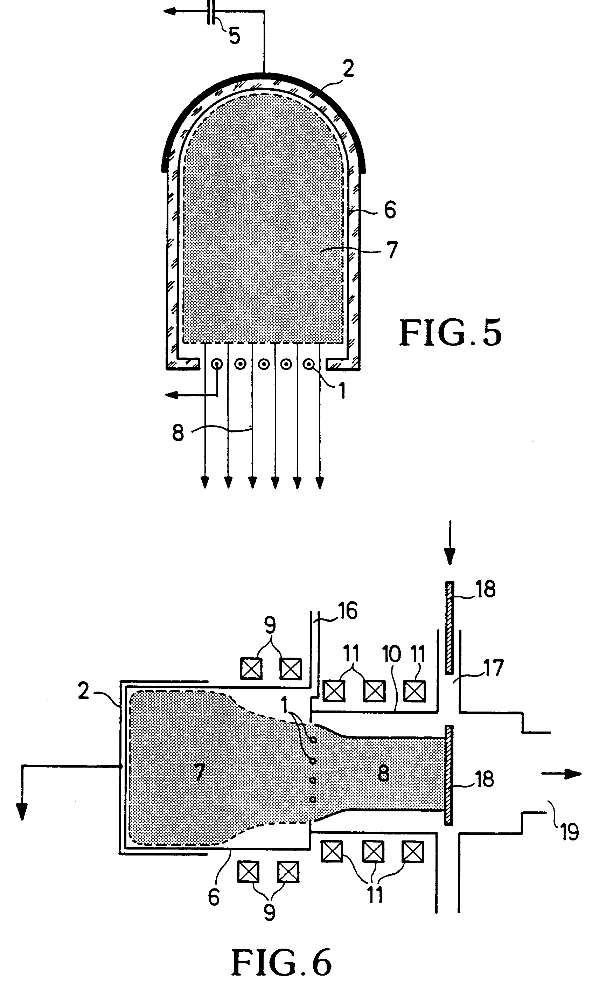

Wesentlich für die Plasmastrahlquelle ist nun, daß eine der beiden Elektroden (1) zur Plasmaerzeugung ganz oder zum Teil in Form eines Extraktionsgitters ausgeführt wird, durch das nach dem oben beschriebenen Prinzip ein Plasmastrahl in eine anschließende Beschußkammer extrahiert wird. Diese Extraktionselektrode 1 steht daher immer in Kontakt mit dem erzeugten Niederdruckplasma. Dagegen kann die zweite Ankoppel-Elektrode 2, wie in Fig. 3, 4 und 5 dargestellt, sowohl innerhalb des Plasmagefäßes 6 sitzen oder einen Teil der Wand dieses Gefäßes bilden oder außerhalb des Plasmagefäßes 6 auf dessen Wandung aufliegen (Fig. 5).

Nach dem oben beschriebenen Prinzip wird die Ionen-Komponente des erzeugten Plasmastrahles 8 duch die sich selbständig einstellende Gleichspannung zwischen dem Plasma und einer hochfrequenzführenden Elektrode, die in Form des Extraktionsgitters 1 ausgeführt ist, beschleunigt. Die kinetische Energie dieser Ionen-Komponente ist in guter Näherung durch die Amplitude der Hochfrequenz-Spannung zwischen dem Extraktions-Gitter 1 und dem Plasma bestimmt.

Für die entwickelte Plasmastrahlquelle ist nun weiter von entscheidender Bedeutung, daß erreicht werden kann, daß nahezu die ganze zwischen die beiden plasmaerzeugenden Elektroden angelegte Hochfrequenz-Spannung an einem der beiden Übergangsbereiche zwischen dem Plasma und den Elektroden abfällt. Als diese Elektrode wird hier das Extraktionsgitter 1 gewählt.

Gemäß diesem Prinzip gilt für die hochfrequenten Teilspannungen $U_1$ und $U_2$, die jeweils zwischen einer der plasmaerzeugenden Elektroden 1, 2 und dem Plasma 7 abfallen, die Beziehung

$$U_1 / U_2 = ( A_2 / A_1 )^a. \qquad (2)$$

mit $a \approx 2$ bis 4.

Anhand dieser Gleichung (2) wird deutlich, daß nahezu die gesamte zwischen den beiden Elektroden liegende Hochfrequenz-Spannung zwischen dem Plasma 7 und der Extraktionselektrode 1 abfällt, wenn nur die von der Extraktionselektrode 1 überdeckte Fläche $A_1$ hinreichend klein ist gegen die Fläche $A_2$ der anderen Elektrode 2 ("Gegenelektrode"). Bereits bei einem in der Praxis leicht realisierbaren Flächenverhältnis $A_1 / A_2$ von etwa 1/3 fallen an der Gegenelektrode 2 nur noch einige % der gesamten Hochfrequenzspannung ab. Dies ist für den praktischen Betrieb einer solchen Plasmastrahl-Quelle sehr vorteilhaft: Da sich auch zwischen der hochfrequenzführenden Gegenelektrode 2 und dem Plasma 7 eine Gleichspannung von der Größenordnung der Hochfrequenz-Amplitude $U_{0,2}$ der dort abfallenden Hochfrequenz-Spannung $U_2$ einstellt, kann wegen der Kleinheit von $U_{0,2}$ eine Zerstäubung des Materials der Gegenelektrode 2 durch die dort auftreffenden Ionen völlig unterbunden werden. Im anderen falle würden sich dann, wenn metallische Teile der Gegenelektrode 2 dem Plasma 7 ausgesetzt sind, an den Innenwänden des Plasmagefäßes 6 sehr rasch störende Metallbeläge aus zerstäubtem Material bilden.

Gleichung (2) gilt, wenn die Plasmadichte n vor den beiden Elektroden 1, 2 gleich groß ist. Ist dies beispielsweise an einer topfförmigen Gegenelektrode 2, in die das Plasma 7 hineinbrennen muß, nicht der Fall, so vergrößert sich dort entsprechend Gleichung (1) die Raumladungsschichtdicke d. Dies führt zu einer Verkleinerung der Schichtkapazität C prop. 1/d und damit zu einer Vergrößerung des hochfrequenten Spannungsabfalls $U_2$ an der Gegenelektrode. Da gilt $U_2$ prop. $1/C_2$ wird $U_2$ unter Umständen ebenfalls vergrößert, wenn im Falle einer von außen auf der Gefäßwand aufliegenden Gegenelektrode 2 (Fig. 5) die Gesamtkapazität $C_2$ zwischen dem Plasma 7 und der Gegenelektrode 2 durch die Hintereinanderschaltung der Schichtkapazität sowie der durch die Gefäßwand bestimmten zusätzlichen Kapazität verkleinert und damit $U_2$ vergrößert wird. Solche und ähnliche Einflüsse lassen sich jedoch durch eine weitere Vergrößerung des Flächenverhältnisses $A_2 / A_1$ auf einfache und sichere Weise korrigieren.

Der in Fig. 2 schematisch dargestellte Hochfrequenzkreis kann an einer beliebigen Stelle geerdet werden. In vorteilhafter Weise wählt man erfindungsgemäß hierfür das Extraktionsgitter 1, das zu diesem Zweck massiv mit Erde verbunden wird. Auf diese Weise tritt der Plasmastahl 8 mit der durch die Hochfrequenz-Amplitude $U_{0,1}$ an der Extraktionselektrode 1 bestimmten kinetischen Energie der Ionenkomponente auf Erdpotential in die Beschußkammer ein. Alle Wände der Beschußkammer, von denen die Extraktionselektrode E einen Teil bildet, sowie alle übrigen Einbauten, wie etwa zu bearbeitende Werkstücke, liegen dann in vorteilhafter Weise ebenfalls auf Erdpotential.

Das Plasma 7 selbst liegt dann wegen des sehr geringen Spannungsabfalls an der Gegenelektrode 2 stets auf dem Potential dieser Elektrode und folgt damit auch potentialmäßig der Variation der Hochfrequenzspannung zwischen der Gegenelektrode 2 und der geerdeten Extraktionselektrode 1.

Die Form des Plasmagefäßes 6 ist im Prinzip beliebig. In vorteilhafter Weise wird es jedoch als ein aus Glas oder Keramik bestehendes Rohrstück ausgeführt, dessen Querschnittsform der jeweils gewünschten Querschnittsform des erzeugten Plasmastrahls angepaßt werden kann. Die beiden Elektroden 1,2 werden dann in vorteilhafter Weise an den beiden Stirnflächen eines solchen Rohrstückes angeordnet.

Zur Verbesserung der Quelleneigenschaften ist es weiterhin vorteilhaft, dem Plasmagefäß 6 geeignet geformte axiale Gleichmagnetfelder zu überlagern, in dem es von außen durch einen Satz von Magnetfeldspulen 9 umgeben wird, in denen das Plasmagefäß 6 konzentrisch angeordnet ist (Fig. 6). In den Bereichen, in denen die Magnetfeldlinien parallel zu den Wänden des Plasmagefäßes 6 verlaufen, ist die Diffusionsbewegung von Plasmateilchen zu den Wänden eingeschränkt, wodurch die sogenannten Wandverluste stark reduziert werden können. Dies führt zu einer Erhöhung der Plasmadichte und damit zu einer Erhöhung der Ionen- und Elektronen-Stromdichte im extrahierten Plasmastrahl 8. Von Wichtigkeit ist weiterhin, daß sich durch eine geeignete Formgebung des Magnetfeldes am Ort der Extraktionselektrode 1 der Plasmastrahl beim Austritt in die Beschußkammer 10 in seiner Gestalt durch weitere Magnetfeldspulen 11 verändern läßt. Damit kann er beispielsweise bezüglich seines Querschnittes komprimiert werden oder erforderlichenfalls hinter dem Extraktionssystem aufgeweitet oder auch seitlich abgelenkt werden. Größe, Richtung und Form der dem Plasmagefäß überlagerten Magnetfelder können durch die geometrische Anordnung der magnetfelderzeugenden Spulen sowie durch geeignete Wahl der Größe und der Richtung der jeweiligen Spulenströme in vielfältiger Weise variiert und geeignet gewählt werden. In Fig. 6 ist mit 16 der Arbeitsgaseinlaß und mit 17 das Werkstück-Einführungssystem bezeichnet. 18 sind in der Beschußkammer 10 zu bearbeitende Werkstücke. Mit 19 ist der Abpumpstutzen bezeichnet.

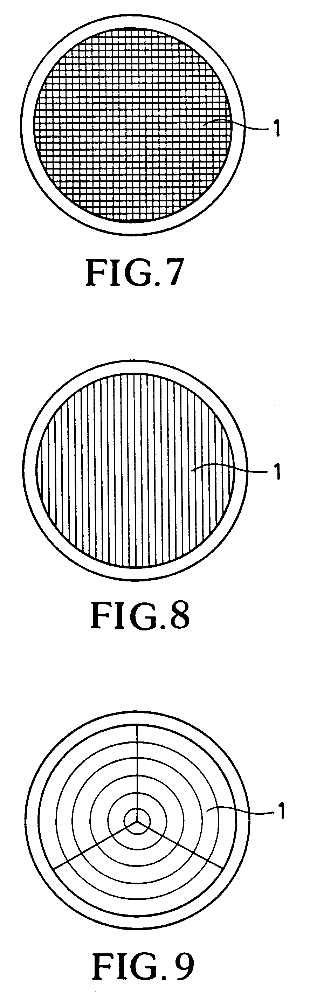

Wie bereits ausgeführt, wird die Extraktionselektrode 1 in vorteilhafter Weise geerdet. Sie kann daher direkt in eine entsprechende Öffnung in der ebenfalls geerdeten Trennwand zwischen Plasmagefäß 6 und Beschußkammer 10 eingelegt oder dort befestigt werden. Die Extraktions-Elektrode 1 soll möglichst hohe Durchlässigkeit für die extrahierten Plasmateilchen aufweisen. Sie wird daher in vorteilhafter Weise in Form eines feinen Gitters bzw. Drahtnetzes mit beliebiger Maschenstruktur ausgeführt. Bedingung hierbei ist lediglich, daß die charakteristischen Abmessungen der Gitteröffnungen kleiner sind als die Dicke der Raumladungsschicht zwischen der Extraktionselektrode 1 und dem Plasma 7. Einige geeignete Gitterformen für die Extraktions-Elektrode sind in Fig. 7, 8 und 9 beispielhaft dargestellt.

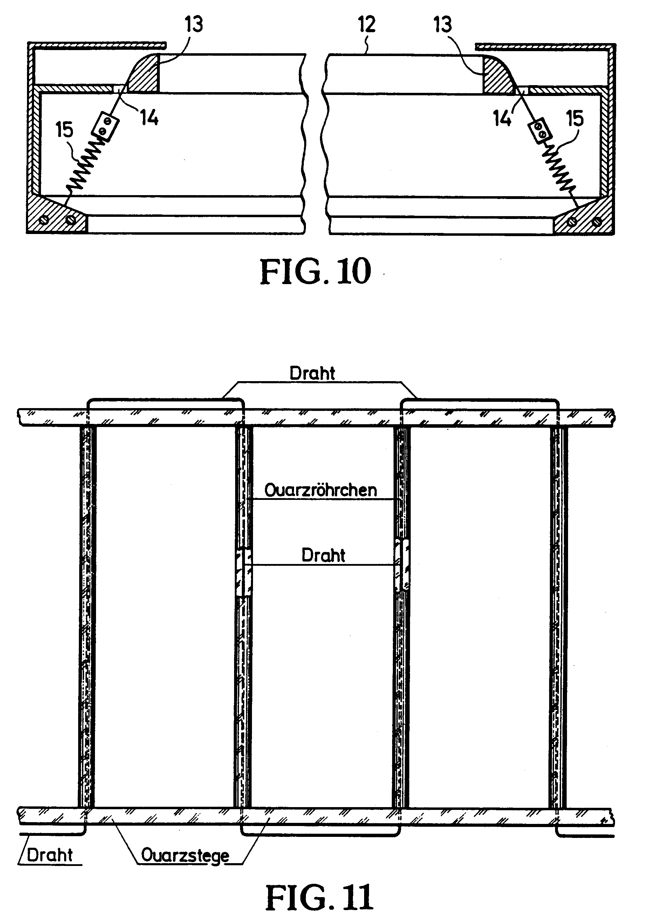

Während des Betriebes der Plasmastrahlquelle können sich durch thermische Belastung die Gitterdrähte der Extraktionselektrode 1 verformen. Um stets eine gute Ebenheit der Fläche der Elektrode 1 aufrechtzuerhalten und eine nachteilige Beeinflussung des Plasmastrahls 8 durch solche Effekte zu vermeiden, wird die Gitterhalterung der Extraktionselektrode 1 in vorteilhafter Weise mit einer Nachspannvorrichtung versehen. Eine mögliche Ausführungsform ist in Fig. 10 gegeben. Der Gitterdraht 12 läuft über einen abgerundeten Wulst 13 durch Bohrungen 14 und bleibt bei Längenänderungen durch die Wirkung der Federn 15 stets gespannt.

Die Gegenelektrode 2 muß lediglich die Bedingung erfüllen, daß ihre dem Plasma 7 zugewandte Fläche ein Mehrfaches der Fläche der gitterförmigen Extraktions-Elektrode 1 sein muß. Sie kann dazu beispielsweise in Form eines Metalltopfes mit einer dem Plasma zugewandten Öffnung ausgeführt werden (Fig. 4). Besonders vorteilhaft ist es, einen Teil der Gegenelektrode 2 in Form eines Bestäubungsschutzes auszuführen, der innerhalb des Plasmagefäßes 6 dicht über den Gefäßwänden angeordnet ist (Fig. 3). Die Verwendung eines solchen Bestäubungs-Schutzes ist im Hinblick auf eine längere Betriebszeit der Plasmastrahlquelle nützlich, da gegebenenfalls auch die metallischen Stege des Extraktionssystems durch die dort auftreffenden energiereichen Ionen des Plasmastrahles zerstäubt werden. Das zerstäubte Material kann sich ohne einen geeignet ausgeformten Zerstäubungsschutz auf den Innenwänden des Plasmagefäßes niederschlagen und dort eine störenden Gleichstrom- oder Hochfrequenzleitfähigkeit zwischen den beiden Elektroden 1 und 2 verursachen. Ein solcher Bestäubungsschutz besteht im einfachsten Fall aus einer Reihe untereinander sitzender geschlossener Metallringe (oder geeignet geformter Metallbänder), die etwa im Abstand von einem bis wenigen Millimetern vor der Innenwand des Plasmagefäßes 6 verlaufen und durch Schattenwirkung die Ausbildung geschlossener metallischer Beläge aus sonst an der Wand auftreffenden zerstäubten Teilchen verhindern. Wie bereits ausgeführt, kann die Gegenelektrode 2 jedoch auch völlig außerhalb des Plasmagefäßes 6 angeordnet sein (Fig. 5).

Wie bereits erläutert, fließen über die beiden Elektroden der hier beschriebenen kapazitiven Anordnungen zur Plasmaerzeugung lediglich dielektrische Verschiebungsströme. Es ist daher nicht erforderlich, daß irgendwelche metallischen, d.h. elektrisch leitenden Teile der Extraktions- oder der Gegenelektrode 1, 2 in direktem Kontakt mit dem Plasma 7 stehen. Beispielsweie können die Stege der Extraktionselektrode in ein Isolator-Material, z.B. in Quarz, eingebettet werden (Fig. 11). Da auch die Gegenelektrode 2 außerhalb des Plasmagefäßes 6 sitzen kann (Fig. 5), wird es auf diese Weise möglich, das Innere des Plasmagefäßes 6 völlig metallfrei und damit resistent gegen chemisch aggressive Medien auszuführen. Damit lassen sich als Plasmagase auch chemisch aggressive Gase benutzen, wie sie etwa für das bereits oben erwähnte reaktive Ionenstrahlätzen RIBE für bestimmte Anwendungszwecke von großer Bedeutung sind. Führt man beispielsweise das Plasmagefäß 6 und den Überzug des Extraktionsgitters 1 völlig in Quarz aus, so wird auf diese Weise die Erzeugung von Plasmastrahlen 8 aus hochreaktiven Gasen möglich, ohne daß es zu irgendeiner Zerstörung der Plasmastrahlquelle kommt.

Aus der vorangehenden Darstellung des Prinzips der Plasmastrahlquelle sowie anhand der mit einem Prototyp erzielten charakteristischen Meßwerte lassen sich folgende Angaben zur praktischen Auslegung solcher Plasmastrahlquellen machen:

Die Querschnittsform und die Querschnittsgröße der nach den verschiedenen Verfahren erzeugten Plasmastrahlen unterliegen prinzipiell keinen Beschränkungen.

Die Frequenz f der benutzten Hochfrequenzspannung muß so gewählt werden, daß die Zeit 1/f, d.h. die Dauer T einer Hochfrequenzperiode, klein gegen die Laufzeit t ist, die aus dem Plasma beschleunigten Ionen zum Durchlaufen der mittleren Raumladungsschichtdicke $\bar{d} = \bar{d} (U_{O,E})$ zwischen dem Plasma und der Extraktionsebene benötigen. Die für die Beschleunigung der Ionenkomponente des Plasmastrahls bestimmende Amplitude $U_{0,1}$ stimmt bei geeigneter Wahl des Flächenverhältnisses der Gegenelektrode 2 und der Extraktionselektrode 1 mit der Amplitude $U_0$ der zwischen den beiden Elektroden liegenden Hochfrequenz-Gesamtspannung überein. Die Ionenenergie im Plasmastrahl 8 kann daher durch Variation der Amplitude der aus einem entsprechenden Generator 4 benutzten Hochfrequenz-Spannung ebenfalls frei gewählt werden.

Die Erfahrungen mit einem Prototyp der Quelle haben gezeigt, daß beim Betrieb der Plasmastrahlquelle mit dem Arbeitsgas Argon bei einem Arbeitsdruck von einigen $10^{-4}$ mbar und einer Hochfrequenzamplitude oberhalb von 500 Volt eine Arbeitsfrequenz von $f \cong 20$ MHz die Bedingung $1/f \gg t$ erfüllt. Die Ionenstromdichte in einem mit dem Prototyp der erfindungsgemäßen Plasmastrahlquelle erzeugten Argon-Plasmastrahl erreichte Werte von etwa 4 mA/cm$^2$ bei guter Homogenität über den gesamten Strahlquerschnitt.

**Patentansprüche**

1. Verfahren zur Abtragung und Strukturierung von Festkörperoberflächen, zur Herstellung von Oberflächendotierungen und zum Erzeugen von Oberflächenschichten durch Teilchenbeschuß aus einem Plasma, dadurch **gekennzeichnet**, daß ein aus gleich viel positiv geladenen Ionen und Elektronen bestehender und im folgenden als Plasmastrahl bezeichneter Teilchenstrahl mit hoher Parallelität und hoher lateraler Homogenität der Stromdichte verwendet wird, der aus einem durch elektrische und magnetische Felder erzeugten Niederdruckplasma dadurch extrahiert wird, daß eine Hochfrequenzspannung an eine Extraktionselektrode und eine weitere Elektrode, zwischen denen sich das Niederdruckplasma befindet, angelegt wird, so daß Ionen dieses Plasmas auf die in Kontakt mit dem Plasma stehende Extraktionselektrode beschleunigt werden, da sich das Plasma gegenüber der Extraktionselektrode von selbst auf ein höheres, positive Plasmaionen beschleunigendes Potential legt, wobei die entsprechende Potentialdifferenz durch die Amplitude der zwischen dem Plasma und der Extrakionselektrode abfallenden Hochfrequenzspannung bestimmt wird und der extrahierte Ionenstrom durch einen im Takt der Hochfrequenz fließenden Elektronenstrom gleicher Höhe zur Kompensation des Ionenstroms überlagert wird, daß das Niederdruckplasma und der extrahierte Plasmastrahl durch Gleichmagnetfelder geeigneter Größe und Konfiguration geformt werden und daß die Extraktionselektrode als feines Gitter ausgebildet ist, deren Öffnungen kleiner sind als die Dicke der Raumladungsschicht zwischen dieser Extraktionselektrode und dem Plasma.

2. Vorrichtung zum Durchführen des Verfahrens nach Anspruch 1, dadurch **gekennzeichnet**, daß ein Plasmagefäß (6) mit zwei großflächigen Elektroden (1, 2) vorgesehen ist, die über ein Anpassungsnetzwerk (3, 5) mit einem Hochfrequenzgenerator (4) verbunden sind und daß die Flächen der Elektroden (1, 2) so gewählt sind, daß nahezu die gesamte Hochfrequenzspannung an der einen als feines Gitter ausgebildeten Extraktionselektrode (1), deren Öffnungen kleiner sind als die Dicke der Raumladungsschicht zwischen dieser Extraktionselektrode und dem Plasma, abfällt.

3. Vorrichtung nach Anspruch 2, dadurch **gekennzeichnet,** daß die weitere Elektrode (2) topfförmig ausgebildet ist und in das Innere des Plasmagefäßes (6) ragend angeordnet ist.

4. Vorrichtung nach Anspruch 2, dadurch **gekennzeichnet**, daß die weitere Elektrode (2) topfförmig ausgebildet und auf das Plasmagefäß (6) aufgesetzt ist.

5. Vorrichtung nach Anspruch 2, dadurch **gekennzeichnet**, daß die weitere Elektrode (2) das Plasmagefäß (6) außen umfassend angeordnet ist.

6. Vorrichtung nach Anspruch 2, dadurch **gekennzeichnet**, daß die als feines Gitter ausgebildete Extraktionselektrode (1) auf einer selbsttätig wirkenden Nachspannvorrichtung (20) befestigt ist.

7. Vorrichtung nach Anspruch 2, dadurch **gekennzeichnet**, daß die Stege der als feines Gitter ausgebildeten Extraktionselektrode (1) in Isolator-Material eingebettet sind.

## Claims

1. A process for removing and structuring solid surfaces, for the preparation of surface dopings and for producing surface layers by particle bombardment from a plasma, characterised in that a particle beam which consists of an equal number of positively charged ions and electrons and which is hereinafter called a plasma beam and in which the current density is highly parallel and has high lateral homogeneity is used, the beam being extracted from a low-pressure plasma produced by electrical and magnetic fields by a high-frequency, hereinafter called hf, voltage being applied to an extraction electrode and another electrode between which the low-pressure plasma is disposed so that ions thereof are accelerated to the extraction electrode in contact with the plasma since the same is at a higher positive plasma-ion-accelerating potential relatively to the extraction electrode, the corresponding potential difference being determined by the amplitude of the hf voltage dropped between the plasma and the extraction electrode, the extracted ion flow having superimposed thereon an electron flow which is of the same level, flows at the cadence of the high frequency and serves to compensate the ion flow,
   the low-pressure plasma and the extracted plasma beam are shaped by DC magnetic fields of appropriate magnitude and configuration, and
   the extraction electrode is in the form of a fine grid whose apertures are smaller than the thickness of the space charge layer between the extraction electrode and the plasma.

2. An apparatus for the practice of the process according to claim 1, characterised in that a plasma vessel (6) has two large-surface electrodes (1, 2) which are connected by way of a matching network (3, 5) to an hf generator (4), and the surfaces of the electrodes (1, 2) are such that substantially the entire hf voltage is dropped across just the one fine-grid extraction electrode (1), whose apertures are smaller than the thickness of the space charge layer between this extraction electrode and the plasma.

3. An apparatus according to claim 2, characterised in that the further electrode (2) is dished and is arranged to extend into the interior of the plasma vessel (6).

4. An apparatus according to claim 2, characterised in that the further electrode (2) is dished and is placed on the plasma vessel (6).

5. An apparatus according to claim 2, characterised in that the further electrode (2) is arranged to engage around the outside of the plasma vessel (6).

6. An apparatus according to claim 2, characterised in that the fine-grid extraction electrode (1) is secured to an automatic adjuster (20).

7. An apparatus according to claim 2, characterised in that the webs of the fine-grid extraction electrode (1) are embedded in insulant.

## Revendications

1. Procédé de gravure et de structuration de la surface de semiconducteurs, pour réaliser des dopages de surface et former des couches de surface par bombardement de particules d'un plasma,
   caractérisé en ce que l'on utilise un faisceau de particules, ci-après faisceau de plasma, à haut parallélisme et haute homogénéité latérale de densité de courant, comprenant autant d'ions chargés positivement que d'électrons qui sont extraits d'un plasma basse pression formé par champs électrique et magnétique,
   en ce qu'une tension haute fréquence est appliquée à une électrode d'extraction et à une électrode supplémentaire, entre lesquelles se trouve le plasma basse pression, de manière que des ions de ce plasma soient accélérés par l'électrode d'extraction en contact avec le plasma, puisque le plasma est porté, par rapport à l'électrode d'extraction, à un potentiel élevé positif accélérateur d'ions de plasma, la différence de potentiel correspondante étant déterminée par l'amplitude de la tension haute fréquence entre le plasma et l'électrode d'extraction, et le courant ionique extrait étant superposé pour sa compensation à un courant d'électrons de même amplitude synchrone à la haute fréquence,
   en ce que le plasma basse pression et le faisceau de plasma extrait sont formés par des champs magnétiques uniformes d'amplitude et configuration adéquates, et
   en ce que l'électrode d'extraction est une grille fine, dont les ouvertures sont plus petites que l'épaisseur de la couche de charge d'espace entre cette électrode d'extraction et le plasma.

2. Dispositif pour mettre en oeuvre le procédé selon la revendication 1, caractérisé en ce qu'il est prévu un réservoir de plasma (6) comprenant deux électrodes de grande surface (1, 2) qui sont reliées par un réseau d'adaptation (3, 5) à un générateur de haute fréquence (4) et en ce que les surfaces des électrodes (1, 2) sont choisies de manière que pratiquement toute la tension haute fréquence soit appliquée à l'électrode d'extraction (1) constituée d'une grille fine dont les ouvertures sont plus petites que l'épaisseur de la couche de charge d'espace entre cette électrode d'extraction et le plasma.

3. Dispositif selon la revendication 2, caractérisé en ce que l'électrode supplémentaire (2) est en forme de cylindre et fait saillie à l'intérieur du réservoir de plasma (6).

4. Dispositif selon la revendication 2, caractérisé en ce que l'électrode supplémentaire (2) est en forme de cylindre et est fixée sur le réservoir de plasma (6).

5. Dispositif selon la revendication 2, caractérisé en ce que l'électrode supplémentaire (2) entoure le réservoir de plasma (6).

6. Dispositif selon la revendication 2, caractérisé en ce que l'électrode d'extraction (1) constituée d'une grille fine est fixée à un dispositif tendeur à action automatique.

7. Dispositif selon la revendication 2, caractérisé en ce que la grille constituant l'électrode d'extraction (1) est encastrée dans un matériau isolant.

$$U_{Pl-E} = \Phi_{Pl} - \Phi_E$$

**FIG.1**

$$\int_0^T j_i \, dt = -\int_0^T j_e \, dt$$

$j_e$ : Elektronenanlaufstromdichte

$j_i$ : Ionensättigungsstromdichte

# FIG. 2

# FIG. 3

# FIG. 4

FIG.5

FIG.6

FIG.7

FIG.8

FIG.9

## FIG. 10

Draht

Ouarzröhrchen

Draht

Draht            Ouarzstege

## FIG. 11